(19) Europäisches Patentamt
European Patent Office
Office européen des brevets

(11) **EP 4 350 055 A1**

(12) **EUROPÄISCHE PATENTANMELDUNG**

(43) Veröffentlichungstag:
**10.04.2024 Patentblatt 2024/15**

(21) Anmeldenummer: **22199997.2**

(22) Anmeldetag: **06.10.2022**

(51) Internationale Patentklassifikation (IPC):
*C30B 15/14* (2006.01)   *C30B 15/30* (2006.01)
*C30B 29/06* (2006.01)   *C30B 30/04* (2006.01)

(52) Gemeinsame Patentklassifikation (CPC):
**C30B 29/06; C30B 15/14; C30B 15/305; C30B 30/04**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siltronic AG**
**81677 München (DE)**

(72) Erfinder:
• **Mangelberger, Karl**
**5122 Ach (AT)**
• **Heuwieser, Walter**
**84533 Stammham (DE)**

(74) Vertreter: **Staudacher, Wolfgang**
**Siltronic AG**
**Intellectual Property -LP 244**
**Johannes-Hess-Str. 24**
**84489 Burghausen (DE)**

(54) **VERFAHREN ZUR HERSTELLUNG EINES EINKRISTALLS AUS SILIZIUM UND HALBLEITERSCHEIBE AUS EINKRISTALLINEM SILIZIUM**

(57)    Halbleiterscheibe aus einkristallinem Silizium und Verfahren zur Herstellung eines Einkristalls aus Silizium durch Ziehen des Einkristalls aus einer Schmelze, die in einem Tiegel enthalten ist und Phosphor und Bor als Dotierstoffe in einem Verhältnis von nicht mehr als 0,41 enthält, wobei die Schmelze Bor mit einer Konzentration von nicht weniger als $5,0 \times 10^{14}$ Atome/cm$^3$ und nicht mehr als $2,2 \times 10^{15}$ Atome/cm$^3$ enthält und der Einkristall einen zylindrischen Abschnitt mit einem Durchmesser von mindestens 300 mm und eine Länge aufweist und beim Ziehen aus der Schmelze von einem Hitzeschild umgeben ist, und wobei ein unterer Rand des Hitzeschilds einen Abstand von nicht weniger als 18 mm zu einer Oberfläche der Schmelze hat, das Verfahren umfassend

das Drehen des Einkristalls mit einer Geschwindigkeit von nicht weniger als 8 Umin$^{-1}$ und nicht mehr als 13 Umin$^{-1}$; und

das Anlegen eines horizontalen Magnetfelds an die Schmelze, dessen magnetische Flussdichte nicht weniger als 2000 Gs und nicht mehr als 3000 Gs beträgt.

**Fig. 3**

EP 4 350 055 A1

**Beschreibung**

Gegenstand der Erfindung ist ein Verfahren zur Herstellung eines Einkristalls aus Silizium durch Ziehen des Einkristalls aus einer Schmelze, die in einem Tiegel enthalten ist und Phosphor und Bor als Dotierstoffe enthält, wobei der Einkristall überwiegend p-dotiert ist und einen zylindrischen Abschnitt mit einem Durchmesser und einer Länge hat. Gegenstand der Erfindung ist auch eine Halbleiterscheibe aus einkristallinem Silizium.

Stand der Technik / Probleme

Das Ziehen eines Einkristalls aus Silizium aus einer Schmelze nach der Czochralski-Methode umfasst das Ziehen eines zylindrischen Abschnitts mit gleichbleibendem Durchmesser. In der Regel werden davon Halbleiterscheiben aus einkristallinem Silizium abgetrennt.

Um zu vermeiden, dass der spezifische elektrische Widerstand eines Einkristalls aus Silizium, der mit Bor dotiert ist, wegen der Segregation von Bor mit der Länge des Einkristalls abnimmt, kann mit Phosphor gegendotiert werden.

In der US 2005 0 252 442 A1 ist ein Verfahren zur Herstellung eines Einkristalls aus Silizium beschrieben, wobei der Einkristall aus einer Schmelze gezogen wird, die in einem Tiegel enthalten ist und Phosphor und Bor als Dotierstoffe in einem Verhältnis von 0,31 enthält, und wobei der Einkristall überwiegend p-dotiert ist und einen zylindrischen Abschnitt mit einem Durchmesser von ungefähr 200 mm hat.

Ebenso wichtig wie das Einhalten eines Zielwiderstands über die Länge des zylindrischen Abschnitts des Einkristalls ist, dass der Widerstand vom Zentrum bis zum Rand des Einkristalls an jeder Längenposition des zylindrischen Abschnitts möglichst wenig vom Zielwiderstand abweicht.

In der EP 2 607 526 A1 ist ein Verfahren zur Herstellung eines Einkristalls aus Silizium beschrieben, wobei der Einkristall aus einer Schmelze gezogen wird, die in einem Tiegel enthalten ist und Phosphor und Bor als Dotierstoffe in einem Verhältnis von 0,42 enthält, und wobei der Einkristall überwiegend p-dotiert ist und einen zylindrischen Abschnitt mit einem Durchmesser von ungefähr 200 mm hat. Die radiale Variation des Widerstands beträgt 1,5 % bezogen auf den größten gemessenen Widerstand.

Die Aufgabe der vorliegenden Erfindung ist, für größere und längere Einkristalle aus Silizium zu erreichen, dass deren spezifischer elektrischer Widerstand im zylindrischen Abschnitt in axialer und radialer Richtung möglichst wenig variiert.

Die Aufgabe der Erfindung wird gelöst durch ein Verfahren zur Herstellung eines Einkristalls aus Silizium durch Ziehen des Einkristalls aus einer Schmelze, die in einem Tiegel enthalten ist und Phosphor und Bor als Dotierstoffe in einem Verhältnis von nicht mehr als 0,41 enthält, wobei die Schmelze Bor mit einer Konzentration von nicht weniger als $5,0 \times 10^{14}$ Atome/cm$^3$ und nicht mehr als $2,2 \times 10^{15}$ Atome/cm$^3$ enthält und der Einkristall einen zylindrischen Abschnitt mit einem Durchmesser von mindestens 300 mm und eine Länge aufweist und beim Ziehen aus der Schmelze von einem Hitzeschild umgeben ist, und wobei ein unterer Rand des Hitzeschilds einen Abstand von nicht weniger als 18 mm zu einer Oberfläche der Schmelze hat, das Verfahren umfassend das Drehen des Einkristalls mit einer Geschwindigkeit von nicht weniger als 8 Umin$^{-1}$ und nicht mehr als 13 Umin$^{-1}$; und das Anlegen eines horizontalen Magnetfelds an die Schmelze, dessen magnetische Flussdichte nicht weniger als 2000 Gs und nicht mehr als 3000 Gs beträgt.

Die Erfinder haben die Merkmale ermittelt, die zur Lösung der Aufgabe notwendig sind.

Die Schmelze muss Bor mit einer Konzentration von nicht weniger als $5,0 \times 10^{14}$ Atome/cm$^3$ und nicht mehr als $2,2 \times 10^{15}$ Atome/cm$^3$ enthalten und mit Phosphor gegendotiert sein, so dass das Verhältnis von Phosphor zu Bor nicht mehr als 0,41 beträgt. Vorzugsweise ist das Verhältnis nicht größer als 0,35 und nicht kleiner als 0,1.

Der Einkristall hat im zylindrischen Abschnitt einen Durchmesser von mindestens 300 mm und wird gemäß der Czochralski-Methode aus der Schmelze gezogen und ist dabei von einem Hitzeschild umgeben. Der Abstand, den der untere Rand des Hitzeschilds zur Schmelze hat, darf nicht weniger als 18 mm betragen. Vorzugsweise beträgt der Abstand 19 bis 25 mm.

Beim Herausziehen aus der Schmelze wird der wachsende Einkristall mit einer Geschwindigkeit gedreht, die nicht weniger als 8 Umin$^{-1}$ und nicht mehr als 13 Umin$^{-1}$ beträgt.

Während des Ziehens des Einkristalls wird an die Schmelze ein horizontales Magnetfeld angelegt, wobei dessen magnetische Flussdichte nicht weniger als 2000 Gauß und nicht mehr als 3000 Gauß beträgt.

Sind die vorstehenden Merkmale erfüllt, gelingt es Halbleiterscheiben vom gezogenen Einkristall zu trennen, bei denen der spezifische elektrische Widerstand vom Zentrum bis zum Rand nicht mehr als 1% variiert, bezogen auf den kleinsten Widerstand. Bei der Messung des Widerstands von Halbleiterscheiben, die vom zylindrischen Abschnitt abgetrennt werden, bleibt ein Randausschluss von 6 mm unberücksichtigt. Die Variation des Widerstands über die axiale Länge des zylindrischen Abschnitts des Einkristalls beträgt nicht mehr als 18%, bezogen auf den mittleren Widerstand, den die erste vom Anfang des zylindrischen Abschnitts abgetrennte Halbleiterscheibe hat.

Der zylindrische Abschnitt des Einkristalls hat einen Durchmesser von mindestens 300 mm und vorzugsweise eine Länge von mindestens 1500 mm.

Gegenstand der Erfindung ist daher auch eine Halbleiterscheibe aus einkristallinem Silizium mit einem Durchmesser von mindestens 300 mm, die überwiegend p-dotiert ist und Phosphor und Bor als Dotierstoffe enthält und deren spezifischer elektrischer Widerstand vom Zentrum bis zum Rand der Halbleiterscheibe um nicht mehr als 1% variiert, bezogen auf den kleinsten Widerstand.

Vorzugsweise beträgt der spezifische elektrische Widerstand der Halbleiterscheibe nicht weniger als 6 Ohmcm und nicht mehr als 30 Ohmcm.

Die Halbleiterscheibe wird vorzugsweise zur Herstellung von elektronischen Bauelementen mit NAND-Logik verwendet.

Die weitere Beschreibung der Erfindung nimmt Bezug auf Zeichnungen.

**Kurzbeschreibung der Figuren**

Fig. 1 zeigt eine Vorrichtung, die zur Durchführung des erfindungsgemäßen Verfahrens geeignet ist, wobei sich die Darstellung auf Merkmale beschränkt, die dem Verständnis der Erfindung dienen.

Fig. 2 zeigt den Verlauf des spezifischen elektrischen Widerstands relativ zum mittleren Widerstand am Anfang des zylindrischen Abschnitts in Abhängigkeit der kristallisierten Menge (FS) an Silizium im Fall eines Beispiels und eines Gegenbeispiels.

Fig. 3 zeigt die radiale Variation des spezifischen elektrischen Widerstands in Abhängigkeit der kristallisierten Menge an Silizium im Fall des Beispiels und des Gegenbeispiels.

**Liste der verwendeten Bezugzeichen**

1    Reaktorkammer
2    Tiegel
3    Welle
4    Antrieb
5    Schmelze
6    Heizvorrichtung
7    Magnetspulen
8    Einkristall
9    Ziehvorrichtung
10   Hitzeschild
11   Abstand

<u>Detaillierte Beschreibung erfindungsgemäßer Ausführungsbeispiele</u>

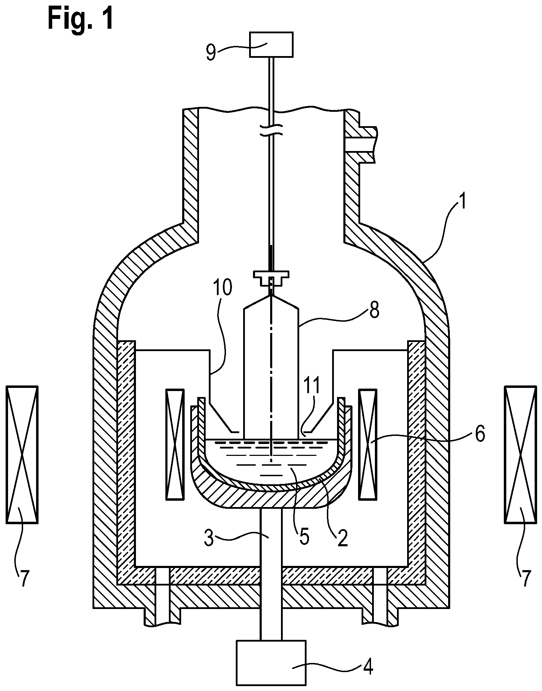

Die Vorrichtung gemäß Fig.1 umfasst eine Reaktorkammer 1, in der ein Tiegel 2 untergebracht ist. Der Tiegel 2 ist auf einer Welle 3 abgestützt und kann mittels eines Antriebs 4 angehoben, abgesenkt und gedreht werden. Der Tiegel 2 enthält eine Schmelze 5 und wird mittels einer ihn umgebenden Heizvorrichtung 6 erhitzt. Die Schmelze enthält Phosphor und Bor als Dotierstoffe in einem Verhältnis von nicht mehr als 0,41, und die Konzentration an Bor beträgt nicht weniger als $5{,}0 \times 10^{14}$ Atome/cm$^3$ und nicht mehr als $2{,}2 \times 10^{15}$ Atome/cm$^3$. Außerhalb der Reaktorkammer 1 sind Magnetspulen 7 angeordnet, die ein horizontales Magnetfeld erzeugen, mit dem die Schmelze beaufschlagt wird. Die magnetische Flussdichte des horizontalen Magnetfelds beträgt nicht weniger als 2000 Gs und nicht mehr als 3000 Gs. Aus der Schmelze 5 wird ein Einkristall 8 aus Silizium mittels einer Ziehvorrichtung 9 gezogen und währenddessen um seine Längsachse mit einer Geschwindigkeit gedreht, die nicht weniger als 8 Umin$^{-1}$ und nicht mehr als 13 Umin$^{-1}$ beträgt. Dabei entsteht ein zylindrischer Abschnitt mit zunehmender Länge und annähernd gleichbleibendem Durchmesser, aus dem später Halbleiterscheiben aus einkristallinem Silizium geschnitten werden. Zum Schutz vor Wärmestrahlung der Heizvorrichtung 6 ist der Einkristall 8 von einem Hitzeschild 10 umgeben. Ein unterer Rand des Hitzeschilds 10 hat einen Abstand 11 zur Oberfläche der Schmelze 5, der nicht weniger als 18 mm beträgt.

Die Erfindung wurde an einem Beispiel getestet und mit einem Gegenbeispiel verglichen.

Es wurden zwei Einkristalle aus Silizium mit einem Nenn-Durchmesser von 300 mm in einer Vorrichtung mit den Merkmalen gemäß Fig.1 gezogen. Im Fall des Beispiels enthielt die Schmelze als Dotierstoffe Phosphor mit einer Konzentration von $4{,}8 \times 10^{14}$ Atome/cm$^3$ und Bor mit einer Konzentration von $1{,}29 \times 10^{15}$ Atome/cm$^3$, im Fall des Gegenbeispiels als Dotierstoff nur Bor mit einer Konzentration von $1{,}2 \times 10^{15}$ Atome/cm$^3$.

In beiden Fällen wurde an die Schmelze ein horizontales Magnetfeld mit einer Flussdichte von 2400 Gs angelegt, betrug der Abstand des unteren Rands des Hitzeschilds zur Oberfläche der Schmelze 20 mm und die Geschwindigkeit, mit der der Einkristall gedreht wurde, 10 Umin$^{-1}$.

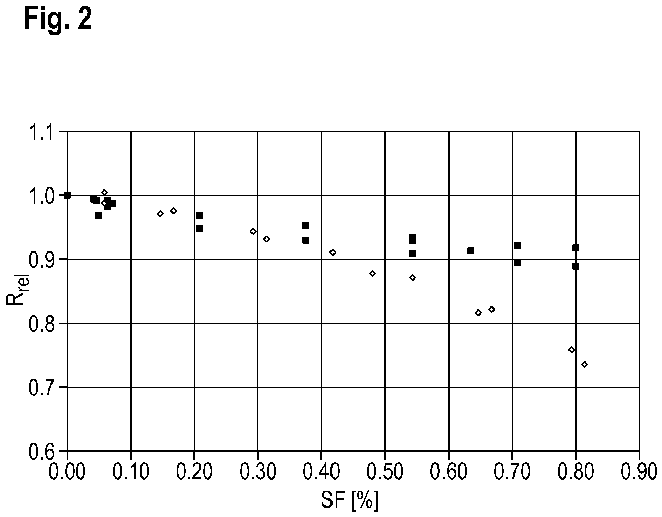

Fig. 2 zeigt den Verlauf des spezifischen elektrischen Widerstands ($R_{rel}$)relativ zum mittleren Widerstand am Anfang des zylindrischen Abschnitts in Abhängigkeit der kristallisierten Menge (SF) an Silizium im Fall des Beispiels und des Gegenbeispiels.

Im Fall des Beispiels fällt der Widerstand bis zu einer kristallisierten Menge von 80% auf nur etwas mehr als 10% des Werts am Anfang des zylindrischen Abschnitts.

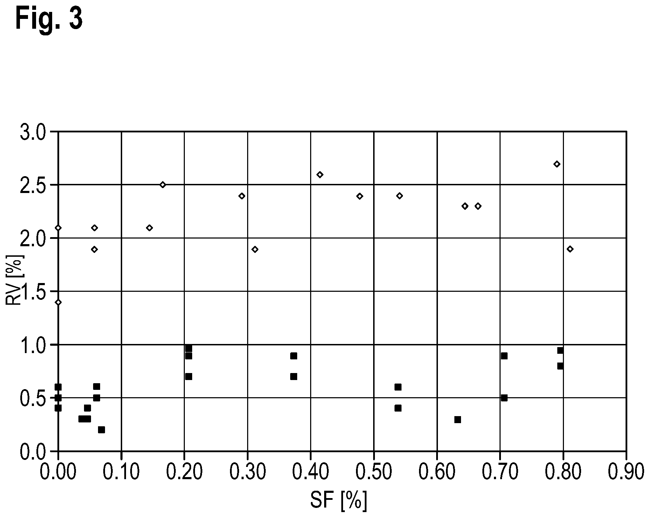

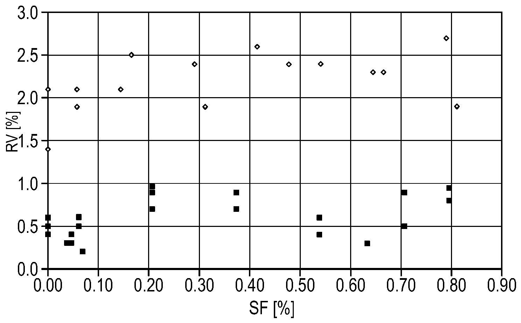

Fig. 3 zeigt die radiale Variation (RV) des spezifischen elektrischen Widerstands in Abhängigkeit der kristallisierten Menge (SF) an Silizium im Fall des Beispiels und des Gegenbeispiels. Der Widerstand wurde gemäß ASTM C gemessen und ein Randausschluss von 6 mm unberücksichtigt gelassen.

Die Berechnung von RV erfolgte nach der Formel

$$RV = ((R_{max} - R_{min}) / R_{min}) \times 100\%$$

wobei Rmax und Rmin den größten beziehungsweise den kleinsten Widerstand bezeichnen.

Im Fall des Beispiels bleibt die radiale Variation vom Anfang des zylindrischen Abschnitts bis zu einer kristallisierten Menge von 80% bei weniger als 1%, bezogen auf den kleinsten Widerstand.

Die Halbleiterscheiben aus einkristallinem Silizium, die vom zylindrischen Abschnitt des Einkristalls des Beispiels geschnitten wurden, hatten einen mittleren spezifischen Widerstand im Bereich von 14 Ohmcm bis 17 Ohmcm.

**Patentansprüche**

1. Verfahren zur Herstellung eines Einkristalls aus Silizium durch Ziehen des Einkristalls aus einer Schmelze, die in einem Tiegel enthalten ist und Phosphor und Bor als Dotierstoffe in einem Verhältnis von nicht mehr als 0,41 enthält, wobei die Schmelze Bor mit einer Konzentration von nicht weniger als $5,0 \times 10^{14}$ Atome/cm$^3$ und nicht mehr als $2,2 \times 10^{15}$ Atome/cm$^3$ enthält und der Einkristall einen zylindrischen Abschnitt mit einem Durchmesser von mindestens 300 mm und eine Länge aufweist und beim Ziehen aus der Schmelze von einem Hitzeschild umgeben ist, und wobei ein unterer Rand des Hitzeschilds einen Abstand von nicht weniger als 18 mm zu einer Oberfläche der Schmelze hat, das Verfahren umfassend

   das Drehen des Einkristalls mit einer Geschwindigkeit von nicht weniger als 8 Umin$^{-1}$ und nicht mehr als 13 Umin$^{-1}$; und
   das Anlegen eines horizontalen Magnetfelds an die Schmelze, dessen magnetische Flussdichte nicht weniger als 2000 Gs und nicht mehr als 3000 Gs beträgt.

2. Verfahren nach Anspruch 1, **dadurch gekennzeichnet, dass** die Länge mindestens 1500 mm beträgt.

3. Verfahren nach Anspruch 1 oder Anspruch 2, **dadurch gekennzeichnet, dass** das Verhältnis nicht größer als 0,35 und nicht kleiner als 0,1 ist.

4. Verfahren nach einem der Ansprüche 1 bis 3, **dadurch gekennzeichnet, dass** der Abstand 19 bis 25 mm beträgt.

5. Halbleiterscheibe aus einkristallinem Silizium mit einem Durchmesser von mindestens 300 mm, die überwiegend p-dotiert ist und Phosphor und Bor als Dotierstoffe enthält und deren spezifischer elektrischer Widerstand vom Zentrum bis zum Rand der Halbleiterscheibe um nicht mehr als 1% variiert, bezogen auf den kleinsten Widerstand und unter Berücksichtigung eines Randausschlusses von 6 mm.

6. Halbleiterscheibe nach Anspruch 5, **gekennzeichnet durch** einen spezifischen elektrischen Widerstand von nicht weniger als 6 Ohmcm und nicht mehr als 30 Ohmcm.

**Fig. 1**

# Fig. 2

# Fig. 3

Europäisches
Patentamt

European
Patent Office

Office européen
des brevets

# EUROPÄISCHER RECHERCHENBERICHT

Nummer der Anmeldung

EP 22 19 9997

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | TENG RAN ET AL: "Experiment and numerical simulation of melt convection and oxygen distribution in 400-mm Czochralski silicon crystal growth", RARE METALS - XIYOU JINSHU, PRESS OF METALLURGICAL INDUSTRY, BEIJING, CN, Bd. 36, Nr. 2, 7. Januar 2017 (2017-01-07), Seiten 134-141, XP036141967, ISSN: 1001-0521, DOI: 10.1007/S12598-016-0865-6 [gefunden am 2017-01-07] | 5 | INV.<br>C30B15/14<br>C30B15/30<br>C30B29/06<br>C30B30/04 |
| A | * Abbildung 5b * | 6 | |
| A | WO 2017/096057 A1 (SUNEDISON SEMICONDUCTOR LTD [SG]; SAMANTA GAURAB [US]) 8. Juni 2017 (2017-06-08) * Abbildungen 1-4 * * Absätze [0029] - [0034], [0066], [0067], [0071], [0072], [0077], [0083], [0085] * | 1-6 | |
| A | WO 2017/137438 A1 (TOPSIL GLOBALWAFERS AS [DK]) 17. August 2017 (2017-08-17) * Abbildung 1 * * Beispiele 1-3 * | 1-6 | RECHERCHIERTE SACHGEBIETE (IPC)<br><br>C30B |
| A | WO 2009/025339 A1 (SUMCO CORP [JP]; ONO TOSHIAKI [JP] ET AL.) 26. Februar 2009 (2009-02-26) * das ganze Dokument * | 1-6 | |

Der vorliegende Recherchenbericht wurde für alle Patentansprüche erstellt

| Recherchenort | Abschlußdatum der Recherche | Prüfer |
|---|---|---|
| Den Haag | 28. Februar 2023 | Schmitt, Christian |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 22 19 9997

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-02-2023

| Im Recherchenbericht angeführtes Patentdokument | Datum der Veröffentlichung | Mitglied(er) der Patentfamilie | Datum der Veröffentlichung |
|---|---|---|---|
| WO 2017096057 A1 | 08-06-2017 | CN 109154103 A | 04-01-2019 |
| | | EP 3384072 A1 | 10-10-2018 |
| | | EP 3831987 A1 | 09-06-2021 |
| | | JP 6987057 B2 | 22-12-2021 |
| | | JP 2018535917 A | 06-12-2018 |
| | | JP 2022033854 A | 02-03-2022 |
| | | KR 20180101358 A | 12-09-2018 |
| | | KR 20220143159 A | 24-10-2022 |
| | | SG 11201804672Q A | 30-07-2018 |
| | | TW 201723244 A | 01-07-2017 |
| | | US 2018355509 A1 | 13-12-2018 |
| | | US 2020392643 A1 | 17-12-2020 |
| | | US 2021348298 A1 | 11-11-2021 |
| | | WO 2017096057 A1 | 08-06-2017 |
| WO 2017137438 A1 | 17-08-2017 | CN 108699724 A | 23-10-2018 |
| | | DK 3414367 T3 | 25-05-2020 |
| | | EP 3414367 A1 | 19-12-2018 |
| | | JP 6808757 B2 | 06-01-2021 |
| | | JP 2019504817 A | 21-02-2019 |
| | | WO 2017137438 A1 | 17-08-2017 |
| WO 2009025339 A1 | 26-02-2009 | JP WO2009025339 A1 | 25-11-2010 |
| | | WO 2009025339 A1 | 26-02-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050252442 A1
- EP 2607526 A1